# EUROPEAN PATENT APPLICATION

(11) **EP 4 560 684 A1**
(43) Date of publication of application: **28.05.2025**
(21) Application number: 24212467.5
(22) Date of filing: 12.11.2024
(51) Int. Cl.: H01L 21/48, H01L 23/15, H01L 23/498

(54) **PACKAGING SUBSTRATE AND SEMICONDUCTOR PACKAGE COMPRISING THE SAME**

(30) Priority: 23.11.2023 US 202363602436 P
(71) Applicant: Absolics Inc., Covington, GA 30014 (US)
(72) Inventor: KIM, Sungjin, Covington, Georgia, 30014 (US); KANG, JUIN, 18469 Hwaseong-si, Gyeonggi-do (KR); KIM, Hyejin, Covington, Georgia, 30014 (US)
(74) Representative: BCKIP Part mbB

(57) **Abstract**

A packaging substrate according to a present disclosure includes a silica-based core. The silica-based core includes a through via portion passing through the silica-based core in a thickness direction of the silica-based core. The through via portion includes a via space which is a space where an electrode is disposed and a via inner diameter surface surrounding the via space. The packaging substrate includes a through electrode disposed in the via space. The through electrode includes metal grain having a preferential orientation in the thickness direction of the silica-based core.

In this case, a packaging substrate having excellent electrical reliability, and in which misalignment of an electrically conductive layer pattern is suppressed when a redistribution layer is formed may be provided.

## Description

### TECHNICAL FIELD

A present disclosure relates to a packaging substrate and a semiconductor package including the same.

### BACKGROUND

In manufacturing electronic components, implementing a circuit on a semiconductor wafer is called a front-end (FE) process, assembling the wafer in a state of being usable in an actual product is called as a back-end (BE) process, and a packaging process is included in the back-end process.

The four core technologies of the semiconductor industry, which recently enabled rapid development of electronic products, include semiconductor technology, semiconductor packaging technology, manufacturing process technology, and software technology. Semiconductor technology has developed in various forms, such as nanoscale (submicron) line widths, 10 million cells or more, high-speed operation, large heat dissipation, and the like, but the packaging technology does not support the semiconductor technology perfectly. Accordingly, the electrical performance of a semiconductor can sometimes be determined by the packaging technology and an electrical connection according to the packaging technology rather than the performance of the semiconductor technology itself.

Recently, research on applying a ceramic material to a high-end packaging substrate is in progress. A line length between an element and a motherboard can be shortened and excellent electrical characteristics can be achieved by forming a through hole in a ceramic substrate and applying a conductive material to the through hole.

### (Related Art Documents)

### (Patent Documents)

Japanese Registration Patent No. 4803964
Japanese Registration Patent No. 5258735.

### SUMMARY

### [Problem to be solved]

The object of the present disclosure is providing a packaging substrate having excellent electrical reliability, and in which misalignment of an electrically conductive layer pattern is suppressed when a redistribution layer is formed.

### [Solutions for the Problem]

A packaging substrate according to one embodiment of the present specification includes a silica-based core.

The silica-based core includes a through via portion passing through the silica-based core in a thickness direction of the silica-based core.

The through via portion includes a via space which is a space where an electrode is disposed and a via inner diameter surface surrounding the via space.

The packaging substrate includes a through electrode disposed in the via space.

The through electrode includes metal grain having a preferential growth orientation in the thickness direction of the silica-based core.

The silica-based core may include a surface.

A contact angle of the surface of the silica-based core for pure water may be 40°or less.

When observed in a cross-section in a thickness direction of the packaging substrate, a cross-sectional area of the through electrode compared to a cross-sectional area of the via space may be 95% or more.

The silica-based core may include an upper surface and a lower surface facing the upper surface.

The via space may include a first opening which is in contact with the upper surface of the silica-based core, a second opening which is in contact with the lower surface of the silica-based core, and a minimum inner diameter portion which is a portion having the smallest inner diameter.

The minimum inner diameter portion may be disposed between the first opening and the second opening.

A thickness of the silica-based core may be 200 µm to 1,000 µm.

A diameter of the through electrode may be 40 µm to 200 µm.

The packaging substrate may include a first redistribution layer disposed on the silica-based core.

The first redistribution layer may include one electrically conductive layer and another electrically conductive layer disposed on the one electrically conductive layer.

A width of the another electrically conductive layer may be narrower than or equal to a width of the one electrically conductive layer.

A method of manufacturing a packaging substrate according to another embodiment of the present specification includes a preparation operation of preparing a silica-based core including a through via portion passing through the silica-based core in a thickness direction of the silica-based core, a through electrode formation operation of forming a through electrode in the through via portion to prepare a through electrode silica-based core, and a manufacturing operation of manufacturing a packaging substrate from the through electrode silica-based core.

The through via portion may include a via space which is a space where an electrode is disposed and a via inner diameter surface surrounding the via space.

In the through electrode formation operation, metal ions may be deposited in one thickness direction of the silica-based core in the via space to form the through electrode.

The silica-based core may include one surface in an in-plane direction of the silica-based core.

The through electrode formation operation may include an electrode seed layer disposition process of disposing an electrode seed layer in parallel with the one surface in the in-plane direction of the silica-based core, and a plating process of depositing the metal ions in the one thickness direction of the silica-based core from the electrode seed layer to form the through electrode.

The silica-based core may include a surface.

A contact angle of the surface of the silica-based core for pure water may be 40 or less.

A thickness of the silica-based core may be 200 µm to 1,000 µm.

A diameter of the through electrode may be 50 µm to 150 µm.

### [Effects of the Invention]

A packaging substrate of a present disclosure may have excellent electrical reliability, and misalignment of an electrically conductive layer pattern may be suppressed when a redistribution layer is formed on the packaging substrate may be provided.

### BRIEF DESCRIPTION OF THE DRAWINGS

FIG. 1a is a cross-sectional view for describing a packaging substrate according to one embodiment of the present disclosure.
FIG. 1b is a cross-sectional view for describing a silica-based core in FIG. 1a.
FIG. 2 is a cross-sectional view for describing a packaging substrate according to another embodiment of the present disclosure.
FIG. 3 is a cross-sectional view for describing a packaging substrate according to another embodiment of the present disclosure.
FIG. 4 is a conceptual diagram for describing an electrode seed layer disposition process in a method of manufacturing the packaging substrate according to another embodiment of the present specification.
FIG. 5a is a side surface image of a packaging substrate of Example 1.
FIG. 5b is a side surface image of a packaging substrate of Comparative Example 1.

### DETAILED DESCRIPTION

Hereinafter, embodiments will be described in detail with reference to the accompanying drawings which may allow those skilled in the art to easily practice the present disclosure. However, the present invention may be implemented in various forms and is not limited to embodiments described herein. The same reference numerals are used for similar components throughout the specification.

Throughout the present specification, the term "combination thereof" included in expression of the Markush form refers to a mixture or combination of one or more selected from a group consisting of components disclosed in the expression of the Markush form, and refers to including the one or more selected from the group consisting of the components.

Throughout the present specification, terms such as "first," "second," "A" or "B" are used to distinguish the same terms. Further, a singular form includes a plural form unless otherwise defined in the context.

In the present specification, "∼-based" may refer to including a compound corresponding to "-" or a derivative of the "∼" in the compound.

In the present specification, "B is disposed on A" means that B is disposed directly on A or B is disposed on A while another layer is disposed therebetween, and is not understood as being limited to a case in which B is disposed on the surface of A.

In the present specification, "B is connected on A" means that B is directly connected to A or B is connected to A through another component therebetween, and is not understood as being limited to a case in which B is directly connected to A unless otherwise specifically mentioned.

In the present specification, a singular form is interpreted as including a singular form or plural form unless otherwise specifically described.

In the present specification, shapes, relative sizes, angles, and the like of components in the drawings are illustrative and may be exaggerated for the purpose of description, and the scope is not understood as being limited to the drawings.

In the present specification, a case in which "B is adjacent to A" means that A and B are located in contact with each other or A and B are located close to each other although not in contact with each other. The expression that "A and B are adjacent to each other" is not understood as being limited to a case in which A and B are located in contact with each other unless otherwise specifically mentioned.

In the present specification, unless otherwise described, a fine line refers to a line having a width of 5 µm or less, for example, refers to a line having a width of 1 to 4 µm or less.

For high integration of a packaging substrate and optimization of a signal transmission path, a through hole may be formed in a silica-based core, and an electrically conductive layer may be formed in the through hole. However, it is difficult to form an electrically conductive layer having stable reliability in the through hole as an inner diameter of the through hole becomes smaller.

When a via filling process of filling metal in the through hole is simply performed, a problem in that the filled metal blocks both openings of the through hole when the process is not yet completed and thus via filling is prevented from proceeding may occur.

A method of forming a metal film on an inner diameter surface of the through hole and filling the inside of the through hole with an insulating resin may also be applied. However, when a redistribution layer is formed on the silica-based core having this structure, it may be difficult for the insulating resin to stably support the redistribution layer. Accordingly, a dimple phenomenon in which the redistribution layer formed on the through hole is depressed downward may occur, and an undulation phenomenon in which a surface of the redistribution layer is wrinkled in a wave shape may occur. These phenomena may cause misalignment of the redistribution layer.

The inventors of the present disclosure first applied a through electrode containing metal grain with controlled preferential growth orientation to the through via portion of the silica-based core. Accordingly, the inventors found that a packaging substrate having excellent electrical reliability and capable of suppressing the misalignment of the redistribution layer formed on the silica-based core may be provided, and completed the present disclosure.

Hereinafter, the present disclosure will be described in detail.

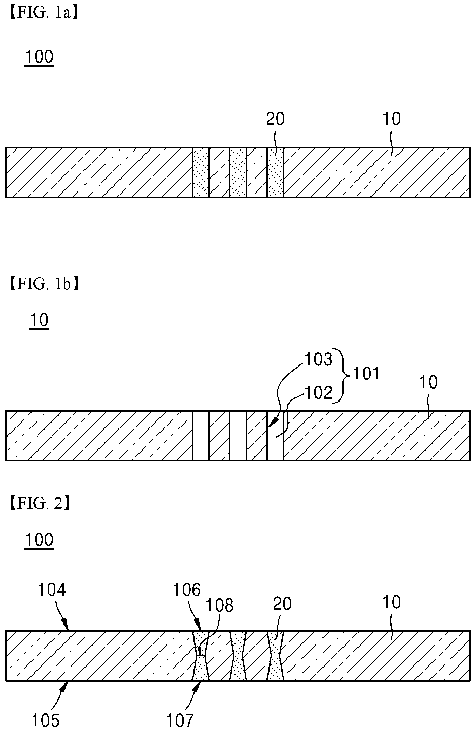

FIG. 1a is a cross-sectional view for describing a packaging substrate according to one embodiment of the present disclosure. FIG. 1b is a cross-sectional view for describing a silica-based core in FIG. 1a. The present disclosure will be described with reference to FIGS. 1a and 1b.

A packaging substrate 100 according to the present disclosure may include a silica-based core 10.

The silica-based core 10 may have a shape of a substrate. The silica-based core 10 is not limited as long as it is a silica-based material substrate applicable to electronic components.

The silica-based core 10 may be a glass core. For example, an alkaline borosilicate glass substrate, an alkali-free borosilicate glass substrate, an alkali-free alkaline earth borosilicate glass substrate, or the like may be applied as the silica-based core 10. A glass substrate for an electronic device may be applied as the silica-based core 10, and for example, products manufactured by manufacturers such as Schott, AGC, Corning, or the like may be applied, but are not limited thereto.

A silica-based core coated with a hydrophilic polymer whose surface energy is adjusted within a predetermined range in the present disclosure to control the surface energy may be applied as the silica-based core 10 as necessary. A silica-based core in which a film whose surface energy is adjusted within a predetermined range in the present disclosure is stacked to control the surface energy may be applied as the silica-based core 10 as necessary.

Surfaces of the silica-based core 10 may include an upper surface (not shown) and side surfaces (not shown) connected to the upper surface and formed in a thickness direction of the silica-based core 10. The surfaces of the silica-based core 10 may include a lower surface facing the upper surface.

A case in which the side surfaces are formed in the thickness direction of the silica-based core 10 is interpreted as a meaning including not only a case in which the side surface forms a right angle with the upper surface of the silica-based core 10, but also a case in which at least a portion of the side surface forms an angle other than 90° (an inclination angle) with the upper surface.

The side surface may be a plane, and may also be a curved surface.

The silica-based core 10 may include a cavity (not shown), which is a space formed as the inside is recessed.

The cavity may be formed as a portion of the upper or lower surface of the silica-based core 10 is recessed in the thickness direction of the silica-based core 10, or may pass through the silica-based core 10 in the thickness direction of the silica-based core 10.

An element may be mounted in the cavity and thus may be electrically connected to the packaging substrate 100. Not only a semiconductor element such as a central processing unit (CPU), a graphics processing unit (GPU), a memory chip, or the like but also a capacitor element, a transistor element, an impedance element, other modules, or the like may be applied as the element. That is, any semiconductor element mounted on a semiconductor device may be applied as the element without limitation.

The silica-based core 10 may include a through via portion 101 passing through the silica-based core 10 in the thickness direction of the silica-based core 10.

The through via portion 101 includes a via space 102 which is a space where an electrode is disposed and a via inner diameter surface 103 surrounding the via space 102.

The via space 102 may have a substantially uniform inner diameter in the thickness direction of the silica-based core 10. The via space 102 may have an inner diameter which changes in the thickness direction of the silica-based core 10.

A cross-section of the via space 102 may have a rectangular shape. The cross-section of the via space 102 may have an hourglass shape, a triangular shape, a trapezoidal shape, or the like in addition to the rectangular shape. The cross-section of the via space 102 refers to a cross-section in the thickness direction of the silica-based core 10.

The via inner diameter surface 103 refers to the surface of the silica-based core 10 formed at the inside of the through via portion 101.

The packaging substrate 100 includes a through electrode 20 disposed in the via space 102. The through electrode 20 may be an electrically conductive layer having a pillar shape. The through electrode 20 may have a diameter which changes in the thickness direction of the silica-based core 10. The through electrode 20 may have a substantially uniform inner diameter in the thickness direction of the silica-based core 10.

A cross-section of the through electrode 20 may have a rectangular shape. The cross-section of the through electrode 20 may have an hourglass shape, a triangular shape, a trapezoidal shape, or the like in addition to the rectangular shape. The cross-section of the through electrode 20 refers to a cross-section in the thickness direction of the silica-based core 10.

The diameter and cross-section of the through electrode 20 may be substantially the same as the diameter and cross-section of the via space 102.

The through electrode 20 may be disposed in the via space 102 to transmit electrical signals in the thickness direction of the silica-based core 10, and may electrically connect an element, a motherboard, a redistribution layer, and the like to each other.

### Properties of silica-based core and through electrode

The through electrode 20 may include metal grain having a preferential growth orientation in the thickness direction of the silica-based core 10. The through electrode 20 may have a preferential growth orientation in the thickness direction of the silica-based core 10.

A metal grain having a preferential growth orientation in the thickness direction of the silica-based core 10 means that a grain size in the thickness direction of the silica-based core 10 is greater than a grain size in an in-plane direction of the silica-based core 10. In another sense, the metal grain having a preferential growth orientation in the thickness direction of the silica-based core 10 means that the number of grain boundaries per unit length in the thickness direction of the silica-based core 10 is smaller than the number of grain boundaries per unit length in the in-plane direction of the silica-based core 10.

When the through electrode 20 has the above-described characteristics, the through electrode 20 may be formed to occupy most of the via space 102. Accordingly, the occurrence of voids in the through electrode 20 or cracks in the surface of the through electrode 20 may be effectively suppressed.

Further, in this case, in the through electrode 20, the number of grain boundaries per unit length in the thickness direction of the silica-based core 10 of the metal grain may be adjusted to a predetermined level or less. Accordingly, the resistance characteristics of the through electrode 20 may be stably adjusted, and this may contribute to lowering the heat generation of the packaging substrate 100 in an element driving process.

The via space 102 may include a first opening (not shown) which is in contact with the upper surface of the silica-based core 10 and a second opening (not shown) which is in contact with the lower surface of the silica-based core 10.

The through electrode 20 may include one end disposed at the first opening side and the other end disposed at the second opening side. A metal grain disposed at the one end of the through electrode 20 may have a preferential growth orientation in the thickness direction of the silica-based core 10. A metal crystal disposed at the other end of the through electrode 20 may have a preferential growth orientation in the thickness direction of the silica-based core 10. In this case, the heat generation characteristics of the packaging substrate may be adjusted by lowering the resistance characteristics of the through electrode 20, and the occurrence of defects such as voids or the like in a process in which the through electrode 20 is formed may be stably suppressed.

The preferential growth orientation of the metal grain included in the through electrode 20 may be measured as follows. The silica-based core is split or the through electrode falls out from the silica-based core to expose a surface of the through electrode. Thereafter, the preferential growth orientation of the surface of the through electrode is measured by taking the metal grain boundaries included in the through electrode through a scanning electron microscope (SEM).

Further, the preferential growth orientation of the metal grain included in the through electrode 20 may be measured through X-ray diffraction (XRD).

A material of the through electrode 20 is not limited as long as it has conductivity. The material of the through electrode 20 may be any one selected from the group consisting of copper, nickel, aluminum, gold, silver, and a combination thereof. The material of the through electrode 20 may be copper.

The silica-based core 10 may include a surface. A contact angle of the surface of the silica-based core 10 for pure water may be 40°or less.

In the present disclosure, the hydrophilicity of the surface of the silica-based core 10 may be adjusted by controlling the contact angle of the surface of the silica-based core 10 for pure water. In this case, when the through electrode 20 is formed through wet electroplating or the like, since affinity between an electrolytic plating solution including metal ions and the via inner diameter surface 103 is improved, the electrolytic plating solution may be uniformly distributed throughout the via space 102. Accordingly, it is possible to help form a through-electrode 20 having a more uniform density in the thickness direction of the silica-based core 10 and in which void formation is suppressed.

The contact angle of the surface of the silica-based core 10 for pure water is measured through a goniometer method using a surface analyzer. Specifically, a 100 µL droplet of pure water, which is a probe liquid, is injected onto the surface of the silica-based core 10, the injected probe liquid is captured, and then the contact angle is calculated from the captured image.

The contact angle of the surface of the silica-based core 10 for pure water may be 40°or less. The contact angle may be 35°or less. The contact angle may be 30°or less. The contact angle may be 25°or less. The contact angle may be 20°or less. The contact angle may be 17°or less. The contact angle may be 1°or more. In this case, defects are suppressed, and it may help form a through electrode 20 with excellent electrical characteristics.

When observed in a cross-section in the thickness direction of the packaging substrate 100, a cross-sectional area of the through electrode 20 compared to a cross-sectional area of the via space 102 may be 95% or more. When observed in the cross-section in the thickness direction of the packaging substrate 100, the cross-sectional area of the through electrode 20 compared to the cross-sectional area of the via space 102 may be 98% or more. When observed in the cross-section in the thickness direction of the packaging substrate 100, the cross-sectional area of the through electrode 20 compared to the cross-sectional area of the via space 102 may be 99% or more. When observed in the cross-section in the thickness direction of the packaging substrate 100, the cross-sectional area of the through electrode 20 compared to the cross-sectional area of the via space 102 may be 100% or less. In this case, when the redistribution layer is formed on the upper surface or lower surface of the packaging substrate 100, the through electrode 20 may stably support the redistribution layer to suppress the occurrence of the dimple phenomenon. Further, the through electrode 20 may stably transmit electrical signals between the element and the redistribution layer or the like.

When observed the cross-section in the thickness direction of the packaging substrate 100, the cross-sectional area of the through electrode 20 compared to the cross-sectional area of the via space 102 may be measured with a transmission electron microscope (TEM).

### Structure of silica-based core and through electrode

FIG. 2 is a cross-sectional view for describing a packaging substrate according to another embodiment of the present disclosure. Hereinafter, the present disclosure will be described with reference to FIG. 2.

The packaging substrate includes a silica-based core. The specific configurations of the packaging substrate are the same as those described above in FIGS. 1a and 1b. Hereinafter, the description will focus on the differences.

The silica-based core 10 may include an upper surface 104 and a lower surface 105 facing the upper surface 104. The via space 102 may include a first opening 106 which is in contact with the upper surface 104 of the silica-based core 10, a second opening 107 which is in contact with the lower surface 105 of the ceramic core 10, and a minimum inner diameter portion 108 which is a portion having the smallest inner diameter. The minimum inner diameter portion 108 may be disposed between the first opening 106 and the second opening 107.

The via space 102 may have an inner diameter which changes in the thickness direction of the silica-based core 10. In the present disclosure, as the minimum inner diameter portion 108 is disposed between the first opening 106 and the second opening 107, the through electrode 20 formed by filling the via space 102 may be prevented from falling out of the silica-based core 10.

An inner diameter of the first opening 106 may be 40 µm to 200 µm. The inner diameter may be 60 µm or more. The inner diameter may be 80 µm or more. The inner diameter may be 100 µm or more. The inner diameter may be 180 µm or less. The inner diameter may be 160 µm or less. The inner diameter may be 140 µm or less. The inner diameter may be 120 µm or less.

A diameter of the through electrode 20 at the first opening 106 may be 40 µm to 200 µm. The diameter may be 60 µm or more. The diameter may be 80 µm or more. The diameter may be 100 µm or more. The diameter may be 180 µm or less. The diameter may be 160 µm or less. The diameter may be 140 µm or less. The diameter may be 120 µm or less.

An inner diameter of the second opening 107 may be 40 µm to 200 µm. The inner diameter may be 60 µm or more. The inner diameter may be 80 µm or more. The inner diameter may be 100 µm or more. The inner diameter may be 180 µm or less. The inner diameter may be 160 µm or less. The inner diameter may be 140 µm or less. The inner diameter may be 120 µm or less.

A diameter of the through electrode 20 at the second opening 107 may be 40 µm to 200 µm. The diameter may be 60 µm or more. The diameter may be 80 µm or more. The diameter may be 100 µm or more. The diameter may be 180 µm or less. The diameter may be 160 µm or less. The diameter may be 140 µm or less. The diameter may be 120 µm or less.

In this case, both high integration and electrical reliability of the packaging substrate 100 may be stably controlled.

An inner diameter of the minimum inner diameter portion 108 may be 50% to 99% of a smaller value of the inner diameter of the first opening 106 and the inner diameter of the second opening 107. The inner diameter of the minimum inner diameter portion 108 may be 60% or more of the smaller value of the inner diameter of the first opening 106 and the inner diameter of the second opening 107. The inner diameter of the minimum inner diameter portion 108 may be 70% or more of the smaller value of the inner diameter of the first opening 106 and the inner diameter of the second opening 107. The inner diameter of the minimum inner diameter portion 108 may be 90% or less of the smaller value of the inner diameter of the first opening 106 and the inner diameter of the second opening 107. The inner diameter of the minimum inner diameter portion 108 may be 80% or less of the smaller value of the inner diameter of the first opening 106 and the inner diameter of the second opening 107. In this case, the through electrode 20 may be stably formed in the thickness direction of the silica-based core 10 without interruption, and the through-electrode 20 may not easily fall out of the silica-based core 10.

In the present disclosure, a packaging substrate 100 having high integration and stable electrical reliability may be provided by controlling both diameters of the silica-based core 10 and the through electrode 20. The diameter of the through electrode 20 refers to an average diameter of the through electrode 20.

A thickness of the silica-based core 10 may be 200 µm or more. The thickness may be 250 µm or more. The thickness may be 400 µm or more. The thickness may be 500 µm or more. The thickness may be 1000 µm or less.

The diameter of the through electrode 20 may be 40 µm to 200 µm. The diameter may be 60 µm or more. The diameter may be 80 µm or more. The diameter may be 100 µm or more. The diameter may be 180 µm or less. The diameter may be 160 µm or less. The diameter may be 140 µm or less. The diameter may be 120 µm or less.

In this case, a packaging substrate 100 having high integration may be provided while forming the through electrode 20 without interruption.

### Another components of packaging substrate

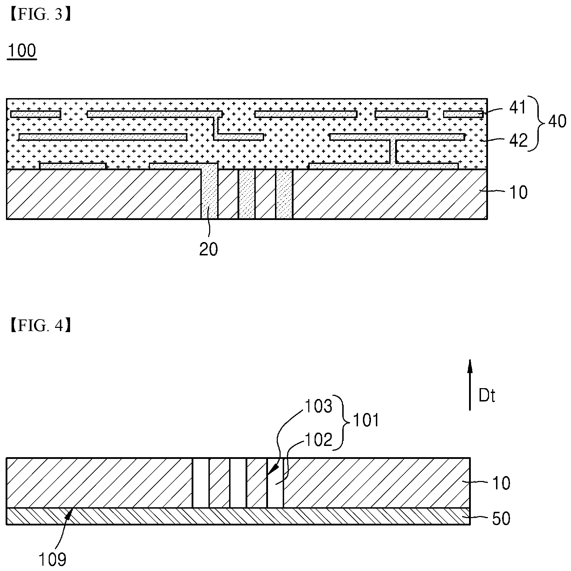

FIG. 3 is a cross-sectional view for describing a packaging substrate according to still another embodiment of the present disclosure. Hereinafter, the present disclosure will be described with reference to FIG. 3.

The packaging substrate includes a silica-based core. The specific configurations of the packaging substrate are the same as those described above in FIGS. 1a, 1b, and 2. Hereinafter, the description will focus on the differences.

The packaging substrate 100 may include a first redistribution layer 40 disposed on the silica-based core 10.

The first redistribution layer 40 may include an electrically conductive layer 41 and an insulating layer 42 surrounding the electrically conductive layer 41.

In the first redistribution layer 40, the insulating layer 42 and the electrically conductive layer 41 may be disposed in a mixed manner. The first redistribution layer 40 may be formed in a form in which the electrically conductive layer 41 having a predetermined position and shape is embedded in the insulating layer 42. The electrically conductive layer 41 may be formed as a fine line in at least a portion of the first redistribution layer 40. The first redistribution layer 40 may be electrically connected to an upper terminal, an element, or the like of the packaging substrate 100.

The first redistribution layer 40 may be formed through a process of repeatedly forming and removing the insulating layer 42 and the electrically conductive layer 41.

The electrically conductive layer 41 corresponds to a conductive wire which transmits electrical signals. The electrically conductive layer 41 may include an electrically conductive material. For example, the electrically conductive layer 41 may include at least any one of copper, nickel, aluminum, gold, silver, or the like. Copper and the like may be used as the material of the electrically conductive layer 41. The material of the electrically conductive layer 41 may be the same as that of the through electrode 20.

Any one which can be applied as an insulating layer to a semiconductor element or packaging substrate may be applied as the insulating layer 42. For example, an insulating layer made of an epoxy-based resin including a filler may be applied as the insulating layer 42. The insulating layer 42 may be formed using, for example, a build-up layer material such as an Ajinomoto build-up film (ABF) of Ajinomoto, an undercoat material, or the like, but is not limited thereto.

The first redistribution layer 40 may include two or more electrically conductive layers 41. The first redistribution layer 40 may include one electrically conductive layer (not shown) and another electrically conductive layer (not shown) disposed on the one electrically conductive layer.

A width of the another electrically conductive layer may be narrower than or equal to a width of the one electrically conductive layer. The width of the another electrically conductive layer may be narrower than the width of the one electrically conductive layer.

A thickness of the another electrically conductive layer may be thinner than or equal to a thickness of the one electrically conductive layer. The thickness of the another electrically conductive layer may be thinner than the thickness of the one electrically conductive layer.

A pitch of the another electrically conductive layer may be smaller than or equal to a pitch of the one electrically conductive layer. The pitch of the another electrically conductive layer may be smaller than the pitch of the one electrically conductive layer.

In the first redistribution layer 40 having a multi-layer structure, an electrically conductive layer having a smaller width may be disposed toward the top. In the first redistribution layer 40 having a multi-layer structure, an electrically conductive layer having a thinner thickness may be disposed toward the top. Accordingly, the packaging substrate 100 may form a stable electrical connection with a semiconductor element having a fine pattern.

The packaging substrate 100 may include a second redistribution layer (not shown) disposed under the silica-based core 10.

The second redistribution layer may include an electrically conductive layer and an insulating layer surrounding the electrically conductive layer. Materials and forming methods of the electrically conductive layer and the insulating layer of the second redistribution layer may be the same as materials and forming methods of the electrically conductive layer and the insulating layer of the first redistribution layer. Descriptions of the electrically conductive layer and the insulating layer of the second redistribution layer overlap the above-described content and thus will be omitted.

The second redistribution layer may include two or more electrically conductive layers. The second redistribution layer may include one electrically conductive layer and another electrically conductive layer disposed under the one electrically conductive layer.

A width of the another electrically conductive layer may be wider than or equal to a width of the one electrically conductive layer. The width of the another electrically conductive layer may be wider than the width of the one electrically conductive layer.

A thickness of the another electrically conductive layer may be thicker than or equal to a thickness of the one electrically conductive layer. The thickness of the another electrically conductive layer may be thicker than the thickness of the one electrically conductive layer.

A pitch of the another electrically conductive layer may be greater than or equal to a pitch of the one electrically conductive layer. The pitch of the another electrically conductive layer may be greater than the pitch of the one electrically conductive layer.

In the second redistribution layer having a multi-layer structure, an electrically conductive layer having a wider width may be disposed toward the bottom. In the second redistribution layer having a multi-layer structure, an electrically conductive layer having a thicker thickness may be disposed toward the bottom. Accordingly, the packaging substrate 100 may form a stable electrical connection with a motherboard formed with a wide or thick electrically conductive layer.

The packaging substrate 100 may further include a bump (not shown) disposed under the second redistribution layer.

The bump may be disposed in a predetermined form under the redistribution layer. For example, the bump may be disposed on a portion of the lower surface of the packaging substrate 100 so as to come into contact with the motherboard or the like.

### Semiconductor package

The semiconductor package according to still another embodiment of the present disclosure includes a packaging substrate and an element electrically connected to the packaging substrate.

The packaging substrate may be mounted on the motherboard and electrically connected to the motherboard.

Descriptions of the packaging substrate and the element overlap the above-described content and thus will be omitted.

### Method of manufacturing packaging substrate

A method of manufacturing a packaging substrate according to another embodiment of the present disclosure includes a preparation operation of preparing a silica-based core including a through via portion passing through the silica-based core in a thickness direction of the silica-based core, a through electrode formation operation of forming the through electrode in the through via portion to prepare a through electrode silica-based core, and a manufacturing operation of manufacturing the packaging substrate from the through electrode silica-based core.

In the preparation operation, the silica-based core may be prepared by preparing a silica-based core in which a through via portion is already formed, or forming a through via portion in a silica-based substrate.

Glass, alumina, aluminum nitride, silicon carbide, silicon nitride, or the like may be applied as a material of the silica-based substrate.

The silica-based substrate may be a glass substrate. For example, an alkaline borosilicate glass substrate, an alkali-free borosilicate glass substrate, an alkali-free alkaline earth borosilicate glass substrate, or the like may be applied as the silica-based substrate. A glass substrate for an electronic device may be applied as the silica-based substrate, and for example, products manufactured by manufacturers such as Schott, AGC, Corning, or the like may be applied, but are not limited thereto.

In the preparation operation, the silica-based core may be prepared by applying a glass substrate as the silica-based substrate and etching the glass substrate. Specifically, defects may be formed at predetermined locations on a surface of the glass substrate. Mechanical etching, laser irradiation, and the like may be applied as a method of forming defects.

After forming the defects, a through via portion may be formed through physical or chemical etching. When chemical etching is applied, wet etching may be performed using an etching solution. The etching solution is not limited as long as it is commonly applicable to etching a glass substrate. For example, a sulfuric acid solution, a nitric acid solution, a hydrofluoric acid solution, or the like may be applied as the etching solution.

In the etching process, the remaining surface of the glass substrate excluding the regions where the defects are formed may be masked, or etching may be performed without masking.

Defects may be formed at one point on an upper surface of the glass substrate, defects may be formed at another point on a lower surface of the glass substrate facing the one point, and etching may be performed to prepare a silica-based core formed with a through via portion.

The through via portion may include a via space which is a space where an electrode is disposed and a via inner diameter surface surrounding the via space.

Descriptions of materials, characteristics, structures, and the like of the silica-based core and components included in the silica-based core overlap the above-described content and thus will be omitted.

To control the surface energy of the silica-based core within a predetermined range in the present disclosure, a hydrophilic polymer may be applied to at least a portion of the surface of the silica-based core, or a hydrophilic film may be stacked on the surface of the silica-based core.

In the through electrode formation operation, a through electrode may be formed by depositing metal ions in one thickness direction of the silica-based core in the via space.

In the present dislcosure, the metal ions may be deposited in an upward direction from a lower side of the via space, or in a downward direction from an upper side of the via space. In this case, in a process in which the metal grain constituting the through electrode grows, the deposited metal grain may be prevented from simultaneously blocking both openings of the through via portion. Accordingly, a plating solution may be stably supplied to a growth surface of the metal grain, thereby filling substantially the entire via space and forming a through electrode with suppressed void formation.

FIG. 4 is a conceptual diagram for describing an electrode seed layer disposition process in a method of manufacturing the packaging substrate according to another embodiment of the present specification. Hereinafter, the present disclosure will be described with reference to FIG. 4.

The silica-based core 10 prepared in the preparation operation may include one surface 109 in an in-plane direction of the silica-based core 10. The one surface 109 may be an upper surface of the silica-based core 10 or a lower surface of the silica-based core 10.

The through electrode formation operation may include an electrode seed layer disposition process of disposing an electrode seed layer 50 in parallel with the one surface 109 in the in-plane direction of the silica-based core, and a plating process of depositing the metal ions in one thickness direction Dt of the silica-based core from the electrode seed layer 50 to form the through electrode.

In the electrode seed layer disposition process, the electrode seed layer 50 may be disposed in parallel with the upper surface or lower surface of the silica-based core 10. The electrode seed layer 50 may be disposed in contact with and in parallel with the one surface 109 of the silica-based core. The electrode seed layer 50 may be disposed in parallel with the one surface 109 of the silica-based core with another component interposed therebetween.

A photoresist layer (not shown) may be disposed between the surface of the electrode seed layer 50 and the one side 109 of the silica-based core. Accordingly, a case in which the one surface 109 of the silica-based core is damaged by coming into contact with the electrode seed layer 50 may be suppressed.

The photoresist layer may be patterned so that the via space 102 may be exposed to the electrode seed layer 50. That is, a photoresist layer patterned so that a region, which is in contact with the via space 102, in the photoresist layer is removed may be applied. In this case, it is possible to prevent the growth of the metal grain in the through electrode from being hindered by the photoresist layer and suppress the formation of a copper film on the one surface 109 in the in-plane direction of the silica-based core in the through electrode formation operation.

The electrode seed layer 50 may be a metal plate including a metal element constituting the through electrode. The electrode seed layer 50 may be a metal thin film including the metal element constituting the through electrode. The electrode seed layer 50 may be a metal tape plated with the metal element constituting the through electrode.

The through electrode formation operation may include a plating process of depositing the metal ions in the one thickness direction Dt of the silica-based core from the electrode seed layer 50 to form the through electrode.

In the plating process, the metal ions may be deposited through electrolytic metal plating. The metal ions may be copper ions, nickel ions, aluminum ions, gold ions, or silver ions. The metal ions may be copper ions.

The plating process may be performed by immersing the silica-based core 10 in an electrolytic plating solution so that a surface of the electrode seed layer 50 and the via inner diameter surface 103 come into contact with the electrolytic plating solution, and applying current to the electrolytic plating solution through an electrode. In this case, the metal ions may begin to be deposited on the electrode seed layer 50 to form the metal grain, and the metal grain may grow in the one thickness direction Dt of the silica-based core to manufacture the through electrode.

In the through electrode formation operation, the silica-based core 10 may include a surface. A contact angle of the surface of the silica-based core 10 for pure water may be 40°or less.

In the through electrode formation operation, the hydrophilicity of the surface of the silica-based core 10 may be adjusted by controlling the contact angle of the surface of the silica-based core 10 for pure water. Accordingly, since the affinity between the via inner diameter surface 103 and the electrolytic plating solution is improved, the through electrode may be stably formed while substantially completely filling the via space.

A measurement method related to the contact angle of the surface of the silica-based core 10 for pure water contact angle and the detailed description of a contact angle range of the surface of the silica-based core 10 overlap the above-described content and thus will be omitted.

The electrolytic plating solution may include a water-soluble copper salt, sulfuric acid, chlorine ions, an accelerator, an inhibitor, a leveler, a wetting agent, a brightener, and the like.

The leveler may include, for example, a polyvinylimidazole-containing compound, a polyvinylpyrrolidone-containing compound, polyethyleneimine and imidazolebased compounds, 3-diethylamino-7-(4-dimethylaminophenylazo)-5-phenylphenaginium chloride, and the like, and a concentration thereof may be 0.01 g/L to 3 g/L or 0.02 g/L to 0.8 g/L based on the entire plating solution.

The brightener may include, for example, sodium 3-mercapto-1-propanesulfonate, and bipyridine, and a concentration thereof may be 0.01 g/L to 3 g/L or 0.02 g/L to 0.5 g/L based on the entire plating solution.

A plating speed may be controlled through a mechanism such as physically blocking the plating solution or disrupting chemical bonds as plating progresses by appropriately adjusting the concentrations of the brightener, the accelerator, the inhibitor, the leveler, and the like.

In the plating process, the current density of electrolytic copper plating may be 3 mA/cm² to 50 mA/cm², and the processing time may be 500 seconds to 2000 seconds.

Accordingly, the occurrence of voids and cracks may be suppressed, and a through electrode capable of preventing the dimple phenomenon of the redistribution layer may be formed.

The through electrode may have a preferential growth orientation in a thickness direction of the silica-based core 10. The description of the preferential growth orientation of the through electrode overlaps the above-described content and thus will be omitted.

After completing the formation of the through electrode, the electrode seed layer 50 and the photoresist layer may be removed to prepare a through electrode silica-based core.

In the manufacturing operation, the through electrode silica-based core may be provided as a packaging substrate. In the manufacturing operation, the packaging substrate may be provided by forming a redistribution layer on and/or under the through electrode silica-based core. The redistribution layer may be a first redistribution layer formed on the silica-based core. The redistribution layer may be a second redistribution layer formed under the silica-based core.

The redistribution layer may include an electrically conductive layer and an insulating layer surrounding the electrically conductive layer. Descriptions of the electrically conductive layer and the insulating layer overlap the above-described content and thus will be omitted.

The electrically conductive layer may be formed using a dry method or wet method.

The dry method is a method of performing sputtering in a region where the electrically conductive layer is to be disposed to form a seed layer and performing plating in a region where the seed layer is formed to form the electrically conductive layer. When the seed layer is formed, metals such as titanium, chromium, nickel, or the like may be sputtered, and the sputtering may be performed by applying the above-described metals and copper together. Since an anchor effect in which metal particles interact with a surface of a glass core, a crack prevention layer, or an insulating layer occurs through sputtering, the adhesion of the electrically conductive layer may be improved.

The wet method is a method of applying a primer to a portion where the electrically conductive layer needs to be formed, and then performing metal plating. The primer may include a compound having a functional group such as an amine or the like. The primer may include a compound having a functional group such as an amine and a silane coupling agent according to the intended degree of adhesion. When the silane coupling agent is applied, a primer layer may be formed by pre-treating a surface to be primed with a silane coupling agent and then applying a compound having an amine group to the pre-treated region.

After forming the seed layer or primer layer, an electrically conductive layer may be formed by plating metal. Copper plating may be applied when the electrically conductive layer is formed, but it is not limited thereto. A portion of the seed layer or primer layer where the electrically conductive layer need not be formed is inactivated, or portions where the electrically conductive layer need to be formed is activated before metal plating, and then plating may be performed. Light irradiation treatment using laser of a specific wavelength, chemical treatment, or the like may be applied as activation or deactivation treatment methods. However, after performing metal plating without applying activation or deactivation treatment, the electrically conductive layer may be etched and patterned according to a previously designed shape.

After forming the electrically conductive layer, an insulating layer surrounding the electrically conductive layer may be formed. The insulating layer manufactured in the form of a film may be applied. Specifically, the insulating layer may be formed by performing pressure reduced lamination on the film-shaped insulating layer. In this case, the insulating layer may be formed to surround the electrically conductive layer without voids, so that the packaging substrate may have excellent electrical reliability.

A process of forming a connection terminal, a bump, a cover layer, and the like on the upper and/or lower surface of the packaging substrate, or mounting an element on the substrate may be further performed as necessary.

Hereinafter, the embodiments will be described in more detail through specific examples. The following examples are only examples for helping understanding of the embodiments, and the scope of the embodiments is not limited thereto.

### Manufacturing Example: Manufacture of packaging substrate

Example 1: After forming defects on a surface of a SG7.8 glass substrate manufactured by Corning through laser irradiation, a plurality of through via portions were formed by performing wet etching to manufacture a silica-based core. An inner diameter of a via space in the through via portion was adjusted to 100 µm.

A photoresist layer was applied on a lower surface of the silica-based core and cured, and the photoresist layer was patterned so that the via space was not blocked by the photoresist layer. A metal tape composed of a copper material, which serves as an electrode seed layer, was attached to a surface of the patterned photoresist layer.

Thereafter, the silica-based core to which the metal tape was attached was immersed in an electrolytic plating solution, and then electrolytic copper plating was performed to form a through electrode in the via space.

After forming the through electrode, a packaging substrate was completed by removing the metal tape and the photoresist layer.

Comparative Example 1: The silica-based core used in Example 1 was prepared. A metal seed layer was formed by performing metal sputtering on a via inner diameter surface of the silica-based core. Specifically, the metal seed layer was completed by applying a nickel target on the via inner diameter surface to form a nickel layer, and applying a copper target on the nickel layer to form a copper layer. The silica-based core in which the metal seed layer was completed was immersed in an electrolytic plating solution, and then the through electrode was formed in the via space by performing electrolytic copper plating in the same manner as in Example 1 to complete a packaging substrate.

Comparative Example 2: A metal seed layer was formed on the via inner diameter surface of the silica-based core under the same conditions as Comparative Example 1. The silica-based core in which the metal seed layer was completed was immersed in the electrolytic plating solution, and then a through electrode of a thickness of 1 µm was formed by performing electrolytic copper plating to complete a packaging substrate.

### Evaluation Example: Measurement of contact angle of silica-based core for pure water

Contact angles of surfaces of the silica-based cores of Example and Comparative Examples for pure water were measured through a goniometer method using a surface analyzer. Specifically, a 100 µL droplet of pure water, which is a probe liquid, was injected onto the surface of the silica-based core, the injected probe liquid is captured, and then the contact angle was calculated from the captured image.

The measured values for Example and Comparative Example are listed in the following Table 1.

### Evaluation Example: Evaluation of whether dimple occurs

A redistribution layer was formed on the packaging substrate for each Example and Comparative Example. Specifically, a metal seed layer was completed by forming a nickel layer on the packaging substrate by applying a nickel target, and forming a copper layer on the nickel layer with a copper target. Thereafter, electrolytic copper plating was performed on the metal seed layer to form an electrically conductive layer with a thickness of 1 µm. A first redistribution layer was formed by disposing an ABF, which is a build-up film manufactured by Ajinomoto, on a patterned electrically conductive layer and performing pressure reduced lamination.

Thereafter, whether a dimple phenomenon occurs was evaluated by observing a surface of the first redistribution layer located on the through electrode with an optical microscope. A case in which the surface was dented by 1 µm or more compared to the surrounding region was evaluated as Fail, and a case in which the surface was dented by less than 1 µm or was smooth compared to the surrounding region was evaluated as Pass.

The evaluation results for Example and Comparative Examples are listed in the following Table 1.

### Evaluation Example: Evaluation of through electrode shape

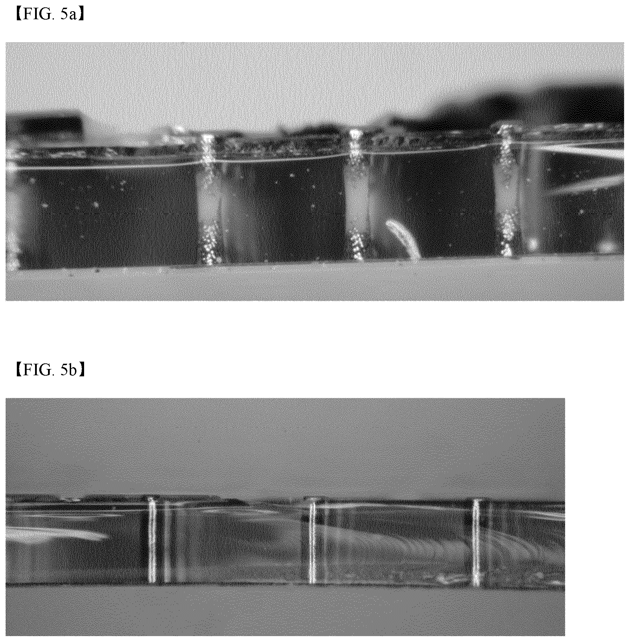

The side surfaces of the packaging substrates of Comparative Examples 1 and 2 were observed with an optical microscope. The side surface image of the packaging substrate of Comparative Example 1 is shown in the following FIG. 5a, and the side surface image of the packaging substrate of Comparative Example 2 is shown in the following FIG. 5b.

**[Table 1]**

| | Contact angle (°) of surface of silica-based core for pure water | Whether dimple occurs |
|---|---|---|
| Example 1 | 14.9 | Pass |
| Comparative Example 1 | 15.1 | Pass |
| Comparative Example 2 | 15.0 | Fail |

In Table 1, in evaluating whether a dimple occurs, Example 1 and Comparative Example 1 were evaluated as Pass, but Comparative Example 2 was evaluated as Fail. This means that the dimple phenomenon may occur when the redistribution layer is formed in the case in which the through electrode does not completely fill the via space.

In FIGS. 5a and 5b, the through electrodes of Comparative Examples 1 and 2 are shown to be formed only in a portion of the via space. This means that a through electrode in which voids are not formed and having excellent electrical reliability may be prepared when a preferential growth orientation of a metal crystal included in the through electrode is a thickness direction of the silica-based core.

Although preferable embodiments of the present invention have been described above in detail, the scope of the present invention is not limited thereto, and various modifications and improvements made by those skilled in the art using the basic concepts of the present disclosure also belong to the scope of the present disclosure.

### [Description of Reference]

100: packaging substrate
10: silica-based core
101: through via portion
102: via space
103: via inner diameter surface
104: upper surface of silica-based core
105: lower surface of silica-based core
106: first opening
107: second opening
108: minimum inner diameter portion
109: one surface in in-plane direction of silica-based core
20: through electrode
40: first redistribution layer
41: electrically conductive layer
42: insulating layer
50: electrode seed layer
Dt: one thickness direction of silica-based core

## Claims

1. A packaging substrate comprising a silica-based core,
wherein the silica-based core comprises a through via portion passing through the silica-based core in a thickness direction of the silica-based core,
the through via portion comprises a via space which is a space where an electrode is disposed and a via inner diameter surface surrounding the via space,
the packaging substrate comprises a through electrode disposed in the via space, and
the through electrode comprises metal grain having a preferential growth orientation in the thickness direction of the silica-based core.

2. The packaging substrate of claim 1,
wherein the silica-based core comprises a surface, and
a contact angle of the surface of the silica-based core for pure water is 40°or less.

3. The packaging substrate of claim 1,
wherein, when observed in a cross-section in a thickness direction of the packaging substrate,
a cross-sectional area of the through electrode compared to a cross-sectional area of the via space is 95% or more.

4. The packaging substrate of claim 1,
wherein the silica-based core comprises an upper surface and a lower surface facing the upper surface,
the via space comprises a first opening which is in contact with the upper surface of the silica-based core, a second opening which is in contact with the lower surface of the silica-based core, and a minimum inner diameter portion which is a portion having the smallest inner diameter, and
the minimum inner diameter portion is disposed between the first opening and the second opening.

5. The packaging substrate of claim 1,
wherein a thickness of the silica-based core is 200 µm to 1,000 µm, and
a diameter of the through electrode is 40 µm to 200 µm.

6. The packaging substrate of claim 1,
comprising a first redistribution layer disposed on the silica-based core,
wherein the first redistribution layer comprises one electrically conductive layer and another electrically conductive layer disposed on the one electrically conductive layer, and
a width of the another electrically conductive layer is narrower than or equal to a width of the one electrically conductive layer.

7. A method of manufacturing a packaging substrate, comprising:
a preparation operation of preparing a silica-based core comprising a through via portion passing through the silica-based core in a thickness direction of the silica-based core;
a through electrode formation operation of forming a through electrode in the through via portion to prepare a through electrode silica-based core; and
a manufacturing operation of manufacturing a packaging substrate from the through electrode silica-based core,
wherein the through via portion comprises a via space which is a space where an electrode is disposed and a via inner diameter surface surrounding the via space, and
in the through electrode formation operation, metal ions are deposited in one thickness direction of the silica-based core in the via space to form the through electrode.

8. The method of claim 7,
wherein the silica-based core comprises one surface in an in-plane direction of the silica-based core, and
the through electrode formation operation comprises an electrode seed layer disposition process of disposing an electrode seed layer in parallel with the one surface in the in-plane direction of the silica-based core, and a plating process of depositing the metal ions in the one thickness direction of the silica-based core from the electrode seed layer to form the through electrode.

9. The method of claim 7,
wherein the silica-based core comprises a surface, and
a contact angle of the surface of the silica-based core for pure water is 40°or less.

10. The method of claim 7,
wherein a thickness of the silica-based core is 200 µm to 1,000 µm, and
a diameter of the through electrode is 50 µm to 150 µm.
